Europäisches Patentamt

**European Patent Office**

**Office européen des brevets**

(19)

(11) Numéro de publication: **0 299 841 B1**

(12) # FASCICULE DE BREVET EUROPEEN

(45) Date de publication de fascicule du brevet: **19.08.92**

(51) Int. Cl.5: **H01L 31/101**, H01L 31/0352, G02F 1/015

(21) Numéro de dépôt: **88401727.8**

(22) Date de dépôt: **04.07.88**

(54) **Détecteur d'onde électromagnétique, et analyseur d'image comportant un tel détecteur.**

(30) Priorité: **17.07.87 FR 8710121**

(43) Date de publication de la demande:
**18.01.89 Bulletin 89/03**

(45) Mention de la délivrance du brevet:
**19.08.92 Bulletin 92/34**

(84) Etats contractants désignés:
**DE GB IT NL SE**

(56) Documents cités:
**EP-A- 0 131 437**
**EP-A- 0 133 342**
**EP-A- 0 183 146**
**EP-A- 0 206 117**
**WO-A-84/03363**

**APPLIED PHYSICS LETTERS, vol. 40, no. 1, 1 janvier 1982, pages 38-40, American Institute of Physics, New York, US; F. CAPASSO et al.: "Enhancement of electron impact ionization in a superlattice: A new avalanche photodiode with a large ionization rate ratio"**

(73) Titulaire: **THOMSON-CSF**
**51, Esplanade du Général de Gaulle**
**F-92800 Puteaux(FR)**

(72) Inventeur: **Delacourt, Dominique**
**THOMSON - CSF SCPI - 19, avenue de Messine**
**F-75008 Paris(FR)**
Inventeur: **Papuchon, Michel**
**THOMSON - CSF SCPI - 19, avenue de Messine**
**F-75008 Paris(FR)**
Inventeur: **Pocholle, Jean-Paul**
**THOMSON - CSF SCPI - 19, avenue de Messine**
**F-75008 Paris(FR)**

(74) Mandataire: **Sciaux, Edmond et al**
**THOMSON-CSF SCPI**
**F-92045 PARIS LA DEFENSE CEDEX 67(FR)**

APPLIED PHYSICS LETTERS, vol. 45, no. 9, 1 novembre 1984, pages 919-921, American Institute of Physics, New York, US; Y. HORI-KOSHI et al.: "New long-wavelength photo-detector based on reverse-biased doping superlattices"

PATENT ABSTRACTS OF JAPAN, vol. 9, no. 110, (E-314)[1833], 15 mai 1985, page 54 E 314; & JP-A-60 785

## Description

L'invention concerne un détecteur d'onde électromagnétique notamment pour détecter et mesurer l'amplitude d'une onde optique au sein d'un matériau semi-conducteur, et un analyseur d'image comportant un tel détecteur.

Dans le domaine des ondes infra-rouges, on connaît deux types de détecteur : les détecteurs pyroélectriques qui peuvent fonctionner à la température ambiante, mais qui sont lents, et les détecteurs à absorption par un matériau semi-conducteur de type II-VI tel que celui décrit dans la Demande de Brevet EP-A1-0 206 117. Ces derniers sont basés sur l'absorption de l'onde à détecter, par une transition d'électrons de la bande de valence vers la bande de conduction du matériau semi-conducteur. Les électrons libres ainsi créés sont ensuite collectés et drainés par un circuit électrique. La mesure du courant correspondant permet de mesurer la puissance optique reçue par le détecteur. Ces dispositifs doivent donc être constitués de matériaux semi-conducteurs pour lesquels la largeur de la bande interdite est inférieure à l'énergie correspondant à l'onde à détecter. Ce fait conduit à utiliser des matériaux semi-conducteurs du type II-VI dont la fabrication est actuellement très délicate. D'autre part, il n'est pas possible de réaliser avec un même matériau semi-conducteur des guides optiques et un détecteur classique, puisque le guide doit être réalisé au moyen de matériaux transparents pour l'onde à propager alors qu'un détecteur classique nécessite d'utiliser un matériau semi-conducteur absorbant pour cette même onde. Il n'est donc pas possible, en optique intégrée, de réaliser sur un même substrat semi-conducteur un guide à faible perte et un détecteur.

Le but de l'invention est de proposer un détecteur constitué de matériaux semi-conducteurs pouvant être réalisés par des techniques de fabrication plus simples, et permettant d'intégrer des guides optiques et un détecteur sur un même substrat.

L'objet de l'invention est un détecteur comportant une structure quantique particulière permettant la détection d'une onde au sein d'un matériau semi-conducteur qui, habituellement, est transparent à la fréquence de cette onde. Par exemple, il peut être constitué de matériaux semi-conducteurs de type III-IV, pour détecter une onde du domaine de l'infra-rouge moyen. Deux variantes de ce détecteur sont proposées :

- selon une première variante, cette structure quantique absorbe systématiquement l'onde à détecter, et n'est donc pas commandable ;
- selon une seconde variante, l'absorption du matériau semi-conducteur peut être commandée, au cours du temps ou localement, par un pompage optique, au moyen d'une onde de commande ayant une fréquence généralement très supérieure à la fréquence de l'onde à détecter. Par exemple l'onde de commande peut être dans le domaine infra-rouge proche alors que l'onde à détecter est dans le domaine d'infra-rouge moyen. Le détecteur peut alors être absorbant à certains instants ou en certains points de sa surface de détection et être transparent à d'autres instants ou en d'autres points.

L'invention a aussi pour objet un analyseur d'image comportant un détecteur conforme à cette seconde variante.

Selon l'invention, un détecteur d'onde électromagnétique pour détecter une onde de fréquence $\nu 1$, comportant :

- au moins une première couche de matériau semi-conducteur d'un premier type, et qui est traversée par l'onde à détecter ;
- au moins deux secondes couches, chaque première couche étant placée entre deux secondes couches et ces secondes couches étant constituées d'un matériau semi-conducteur d'un second type, ces deux types de matériau étant tels qu'il y ait un puits de potentiel dans la bande de conduction et dans la bande de valence de chaque première couche ;
- deux électrodes disposées parallèlement auxdites couches pour appliquer un champ électrique, à l'ensemble des premières et des secondes couches perpendiculairement à ces couches et pour recueillir un courant électrique fonction de l'amplitude de l'onde à détecter,

est caractérisé en ce que l'épaisseur de chaque première couche est telle que les électrons de la bande de conduction de chaque première couche possèdent au moins un niveau discret d'énergie permis, tel que la différence d'énergie entre ce niveau, et le bas de la bande de conduction dans les secondes couches soit inférieure ou égale à l'énergie correspondant à la fréquence $\nu 1$ de l'onde à détecter ; ce niveau étant peuplé d'électrons ; de plus, les largeurs de bandes interdites de la première couche et des secondes couches de matériaux semiconducteurs étant supérieures à l'énergie de l'onde à détecter.

L'invention sera mieux comprise et d'autres détails apparaîtront à l'aide de la description ci-dessous et des figures l'accompagnant :

- la figure 1 représente un diagramme des niveaux d'énergie des porteurs dans la structure quantique que comporte le détecteur selon l'invention ;
- la figure 2 représente un diagramme des niveaux d'énergie des porteurs dans cette structure quantique pour un exemple de choix de matériaux semi-conducteurs ;

- les figures 3a, 3b, 3c représentent un premier exemple de réalisation du détecteur selon l'invention, conformément à la première variante ;
- les figures 4a, 4b, 4c représentent un deuxième exemple de réalisation d'un détecteur selon l'invention, conformément à la seconde variante ;
- la figure 5 représente une partie du deuxième exemple de réalisation ;
- la figure 6 représente un exemple de réalisation, d'un analyseur d'image comportant un détecteur selon l'invention ;
- les figures 7a, b, c représentent un troisième exemple de réalisation du détecteur selon l'invention, destiné plus particulièrement à détecter une onde guidée selon une seule dimension ;
- la figure 8 représente un quatrième exemple de réalisation, destiné plus particulièrement à détecter une onde guidée selon deux dimensions ;
- la figure 9 représente l'application du quatrième exemple de réalisation à la mesure de la puissance optique le long d'un guide ;
- la figure 10 représente l'application du quatrième exemple de réalisation à la mesure de la puissance optique le long d'un coupleur optique.

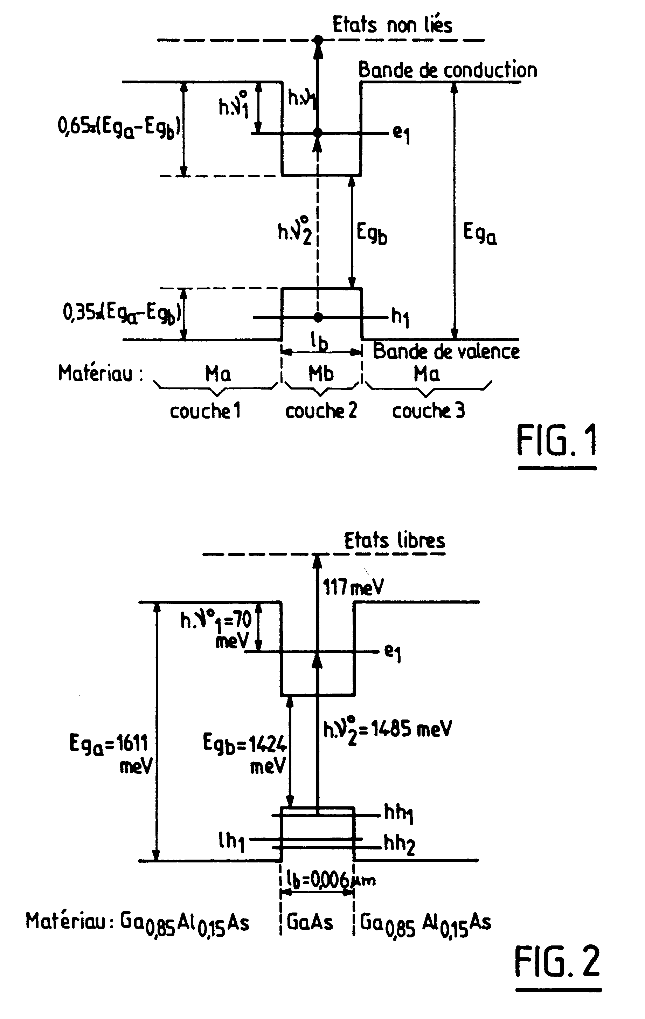

Le diagramme de la figure 1 représente les niveaux d'énergie des porteurs dans la structure quantique utilisée dans le détecteur selon l'invention. Cette structure quantique comporte : une couche 2 de matériau semi-conducteur d'un premier type, noté $M_b$ , et deux couches, 1 et 3, d'un matériau semi-conducteur d'un second type, noté $M_a$ , situées de part et d'autre de la couche 2. Les couches 1 et 3 ont une bande interdite de largeur $E_{ga}$ alors que la couche 2 a une bande interdite de largeur $E_{gb}$ inférieure à $E_{ga}$. Il est généralement admis que la différence entre ces deux largeurs se répartie entre la bande de conduction et la bande de valence selon les proportions 65% et 35% respectivement.

L'association de ces trois couches de matériaux semi-conducteurs ayant des largeurs de bande interdite différentes permet la création d'un puits de potentiel pour les électrons dans la bande de conduction, et pour les trous dans la bande de valence. Lorsque les dimensions de ce puits sont proches des longueurs d'onde de Broglie associées à ces particules, l'énergie totale qui leur est permise ne peut prendre qu'un nombre fini de valeurs discrètes. Ce nombre de valeurs et ces valeurs sont directement fonctions des dimensions du puits quantique et des caractéristiques des matériaux semi-conducteurs. La structure quantique utilisée dans le détecteur selon l'invention a une seule dimension : l'épaisseur, $1_b$ , de la couche 2. Le puits possède alors au moins un niveau discret d'énergie permis, $e_1$ , pour les électrons dans la bande de valence, et au moins deux niveaux $h_1$ et $h_2$ pour les trous dans la bande de conduction. Pour simplifier, sur cette figure, tous les trous de la bande de valence sont supposés posséder les mêmes caractéristiques, ce qui conduit à l'existence de seulement deux niveaux discrets d'énergie permis $h_1$ et $h_2$ .

Si le niveau $e_1$ est peuplé d'électrons, une onde de fréquence $\nu_1$ peut être détectée et absorbée par une transition du niveau $e_1$ vers le continuum des états non liés, situés au dessus de la barrière de potentiel, à condition que l'énergie h. $\nu_1$ de l'onde à détecter, h étant la constante de Planck, soit supérieure à une énergie h. $\nu_1^0$ égale à la barrière de potentiel, c'est-à-dire égale à la différence d'énergie entre le niveau fondamental $e_1$ permis pour les électrons dans la bande de conduction de la couche 2 et le bas de la bande de conduction dans les couches 1 et 3. Pour que le niveau fondamental $e_1$ de la bande de conduction de la couche 2 soit peuplé d'électrons, deux variantes de réalisation sont possibles.

Selon une première variante, la couche 2 est constituée d'un matériau semi-conducteur assez fortement dopé, avec un dopant de type N, pour permettre une détection sans que le détecteur soit saturé. L'onde à détecter est alors systématiquement absorbée. Selon une seconde variante, la couche 2 est constituée d'un matériau semi-conducteur non dopé, c'est-à-dire ayant un dopage résiduel aussi faible que possible avec les technologies connues. Le peuplement du niveau fondamental $e_1$ est alors réalisé par un pompage optique, en illuminant la couche 2 par une onde de fréquence $\nu_2$ proche de la fréquence $\nu_2^0$ correspondant à la différence d'énergie entre le niveau fondamental $h_1$ permis pour les trous dans la bande de valence, et le niveau fondamental $e_1$ permis pour les électrons dans la bande de conduction du matériau de la couche 2. L'absorption de l'onde à détecter, de fréquence $\nu_1$, ne peut alors se faire que lorsque l'onde de commande, de fréquence $\nu_2$, illumine la couche 2.

La fréquence $\nu_2$ est supérieure à la fréquence $\nu_1$ à cause de la configuration des niveaux d'énergie dans la couche 2, et peut appartenir à un domaine spectral très différent de celui de $\nu_1$ . Par exemple, l'onde à détecter peut être du domaine infra-rouge moyen alors que l'onde de commande peut être du domaine infra-rouge proche. En l'absence de l'onde de commande, la couche 2 est parfaitement transparente. Les couches 1 et 3 sont réalisées aussi dans un matériau semi-conducteur peu ou pas dopé, ce qui permet d'obtenir un détecteur transparent pour l'onde à détecter en l'absence de l'onde de commande. Ce détecteur peut être inséré sur le chemin de l'onde à détecter sans provoquer la disparition de celle-ci tant qu'il n'est pas commandé pour réaliser la détection. Cette propriété du détecteur selon l'invention est un avantage par rapport aux détecteurs classiques qui absorbent l'onde à détecter sitôt qu'ils sont placés sur le trajet de celle-ci. D'autre part, le détecteur selon l'invention peut être intégré à un guide optique, pour faire une mesure de la puissance optique à certains instants, sans perturber la propagation de la lumière pendant le reste du temps.

Enfin, il est possible de n'illuminer qu'une très petite portion de la surface de la couche 2 afin de détecter la puissance optique en un point précis de cette couche, pour analyser point par point la puissance optique traversant cette couche. Cette structure permet donc de réaliser un analyseur d'images à balayage optique ou un dispositif de mesure point par point de la puissance optique dans un guide optique.

Le principe de fonctionnement du détecteur selon l'invention, permet l'utilisation de matériaux semi-conducteurs de types III-V et en particulier des alliages du type $Al_xGa_{1-x}As$ dont la technologie est très classique.

La figure 2 représente un diagramme analogue à celui de la figure 1, pour un exemple de réalisation destiné à détecter une onde de longueur d'onde 10,6 micromètres correspondant à une énergie de 117 meV, lorsque le détecteur est illuminé par l'onde de commande. Les couches 1 et 3 sont constituées de $Ga_{0,85}Al_{0,15}As$ et la couche 2 est constituée de GaAs. Pour ces matériaux, $E_{ga}$ est égal à 1611 meV et $E_{gb}$ est égal à 1424 meV. Pour une épaisseur $l_b$ = 0,006 micromètres, les niveaux d'énergie permis sont tels que la transition du niveau fondamental $e_1$ jusqu'au niveau le plus bas de la bande de conduction dans les couches 1 et 3 est égale à 70 meV.

Avec ces matériaux, l'épaisseur $l_b$ de la couche 2 constituant le puits quantique doit être inférieure à 0,0068 micromètre pour que les électrons ne possèdent qu'un seul niveau discret d'énergie permis dans la bande de conduction. D'autre part, pour que le détecteur puisse fonctionner à la température ambiante, il faut que la barrière de potentiel, de valeur h. $\nu_1^0$, à franchir pour les électrons, soit supérieure à k.T = 26 meV, k étant la constante de Boltzmann et T étant égale à 300 K. Enfin, la hauteur de cette barrière doit être inférieure à 117 meV, pour pouvoir détecter une longueur d'onde de 10,6 micromètres. Par conséquent la valeur h. $\nu_1^0$ doit être comprise entre 26 et 117 meV. Dans cet exemple, le choix des matériaux et le choix d'une largeur $l_b$ = 0,006 micromètre conduit à une hauteur de la barrière de potentiel égale à 70 meV, ce qui convient pour absorber la configuration d'onde à détecter : 10,6 micromètres.

Les trous lourds ont deux niveaux d'énergie permis, $hh_1$ et $hh_2$, alors que les trous légers ont un seul niveau permis, $lh_1$, dans la bande de valence de la couche 2. La différence d'énergie h. $\nu_2^0$ entre le niveau fondamental $hh_1$ pour les trous dans la bande de valence et le niveau fondamental $e_1$ pour les électrons dans la bande de conduction est égale à 1485 meV, ce qui correspond à une longueur d'onde de 0,93 micromètre appartenant au domaine de l'infra-rouge très proche. L'existence de deux familles de trous : les trous légers et les trous lourds, ainsi que l'existence de deux niveaux permis pour les trous lourds, ne change pas le principe de fonctionnement du détecteur, décrit précédemment en se référant à la figure 1.

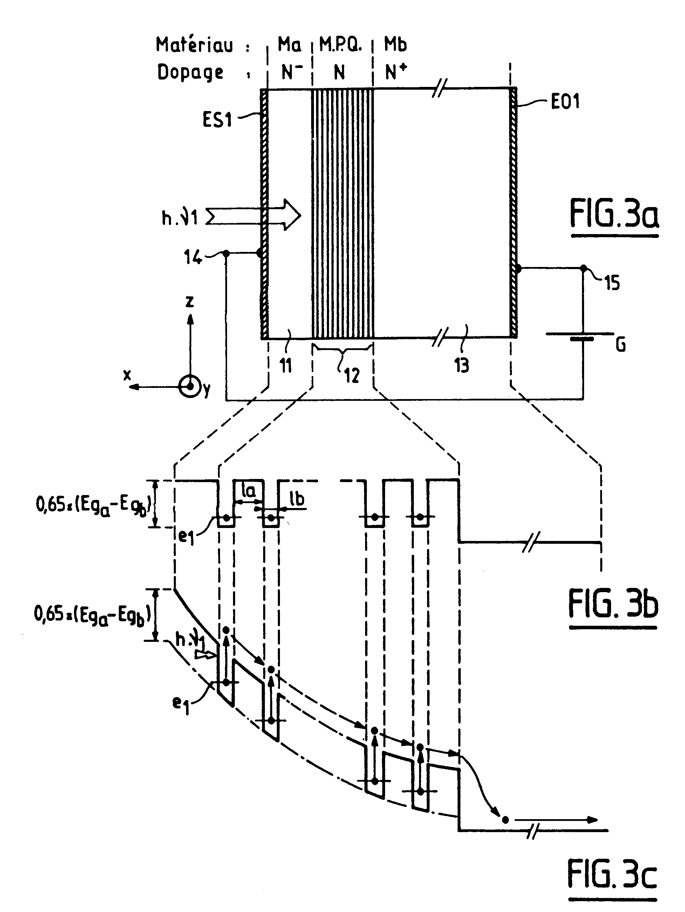

La figure 3a représente schématiquement un premier exemple de réalisation d'un détecteur selon l'invention, conformément à la première variante, pour détecter une onde non guidée, notée h. $\nu_1$. Cet exemple de réalisation comporte : une électrode Schottky, ES1 ; une couche 11 constituée d'un matériau $M_a$ ; un ensemble de couches, 12, appelé multipuits quantique (M.P.Q.) et constitué d'une succession périodique de couches de matériau $M_a$ d'épaisseur $l_a$ et de couches de matériau $M_b$ d'épaisseur $l_b$ ; une couche 13 constituée de matériau $M_b$ ; et une électrode ohmique, EO1. L'électrode ES1 est connectée par une borne 14 à un circuit électrique comportant un générateur de tension continue G. L'électrode EO1 est reliée par une borne 15 à ce même circuit électrique.

L'onde à détecter h. $\nu_1$ est appliquée perpendiculairement aux couches, à travers l'électrode ES1 qui est réalisée de manière à être transparente pour la fréquence $\nu_1$. Pour cela, différents modes de réalisation sont possibles : une très faible épaisseur, ou une structure en grille, etc... La couche 11 possède un dopage résiduel de type N, qui doit être le plus faible réalisable par la technologie connue, pour ne pas absorber l'onde de fréquence $\nu_1$. Les couches de l'ensemble 12 ont un dopage de type N pour peupler d'électrons le niveau permis $e_1$ des puits quantiques, suffisamment pour qu'il n'y ait pas saturation du détecteur par l'onde à détecter. $M_a$is ce dopage doit néanmoins être compatible avec la tension limite que peut supporter l'électrode ES1 et qui régit le champ électrique maximal applicable au sein des couches 12 et 13. La couche 13 constitue le substrat du détecteur et a un dopage de type N très important afin de faciliter l'obtention d'un caractère ohmique pour l'électrode EO1.

Dans cet exemple de réalisation, l'onde à détecter étant absorbée par l'ensemble de couches 12, l'électrode EO1 peut ne pas être transparente pour la fréquence $\nu_1$. Les couches de l'ensemble 12 sont analogues aux couches 1, 2, 3, décrites précédemment à propos des figures 1 et 2. Elles peuvent être au nombre de 100 par exemple. Les épaisseurs $l_a$ et $l_b$ sont telles que les puits quantiques formés dans les couches de matériau $M_b$ ont des propriétés identiques à celles décrites précédemment. La largeur $l_a$ des barrières de potentiel séparant les puits quantiques est choisie suffisamment grande pour interdire un couplage entre ces puits, c'est-à-dire pour que l'état d'un électron dans un puits soit indépendant de l'état des électrons dans les autres puits. L'épaisseur $l_b$ est choisie telle que les puits quantiques possèdent au moins un niveau discret d'énergie permis dans la bande de conduction. La multiplicité du nombre de puits a pour effet d'augmenter le nombre d'électrons disponibles sur le niveau fondamental $e_1$, ce qui repousse le seuil de saturation du détecteur. L'épaisseur de la couche 11 n'est pas critique car son seul rôle est de protéger le puits quantique de la dernière couche de matériau $M_b$ de l'ensemble 12, du côté de l'électrode ES1.

Les figures 3b et 3c représentent des diagrammes des niveaux d'énergie des électrons dans les différentes couches de cet exemple de réalisation, respectivement lorsqu'aucune différence de potentiel n'est appliquée aux bornes 14 et 15, et lorsqu'une différence de potentiel positive est appliquée à la borne 15 par rapport à la borne 14, c'est-à-dire lorsque le dispositif est polarisé en inverse pour détecter et collecter les électrons ayant transité du niveau fondamental $e_1$ vers le continuum des états non liés. Un faible champ électrique dû à l'électrode Schottky a été négligé et n'est pas représenté. Sur ces figures, les électrons sont représentés par un point noir ; leur niveau fondamental est représenté par un trait horizontal ; et leur déplacement est représenté par une flèche.

Sur la figure 3b, chaque couche de l'ensemble de couches 12 possède un puits quantique comportant des électrons sur le niveau fondamental $e_1$. Sur la figure 3c, le champ électrique créé par le générateur G est maximal à l'interface entre l'électrode ES1 et la couche 12 puis il décroît de ES1 à l'électrode EO1. Lorsqu'une onde h. $\nu_1$ est absorbée, les électrons franchissent la barrière de potentiel des puits quantiques, sont déplacés par le champ électrique créé par le générateur G, et constituent un courant dont l'intensité est mesurable et traduit la puissance optique détectée.

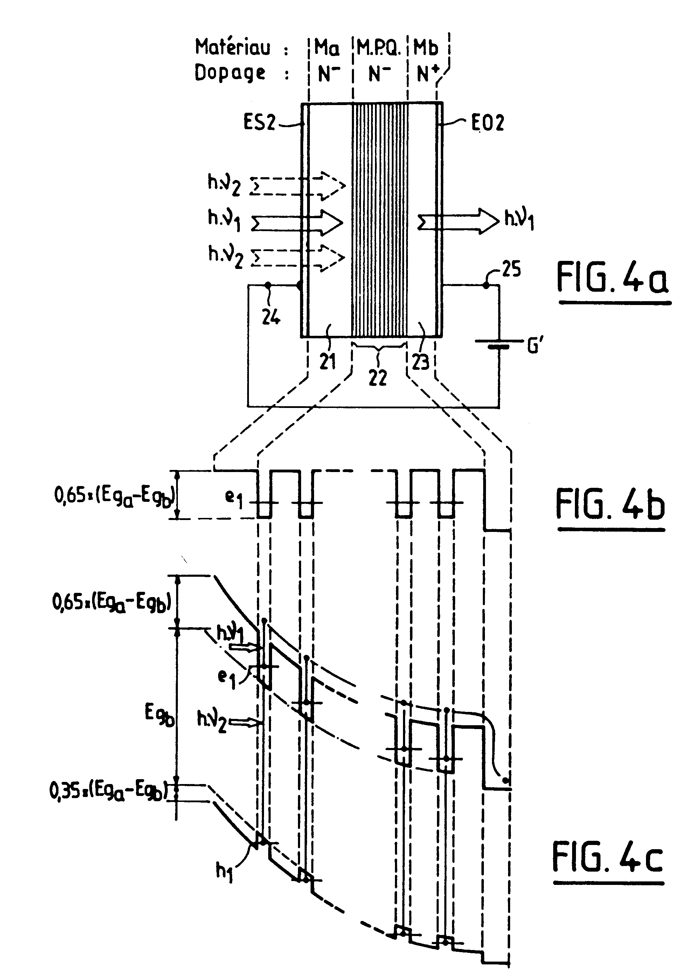

La figure 4a représente schématiquement un second exemple de réalisation du détecteur selon l'invention, pour détecter une onde non guidée, conformément à la seconde variante. Une onde de commande, h. $\nu_2$, est appliquée, en même temps que l'onde à détecter, h. $\nu_1$, perpendiculairement au plan des couches constituant le détecteur. En l'absence de l'onde de commande h. $\nu_2$, l'onde h. $\nu_1$ traverse le dispositif et ressort pratiquement sans affaiblissement. Cet exemple de réalisation comporte : une électrode Schottky, ES2, transparente à la fois pour l'onde à détecter et pour l'onde de commande ; une couche 21 constituée de matériau $M_a$ ; un ensemble de couches, 22, constituant un multipuits quantique ; une couche 23 constituée de matériau $M_b$ ; et une électrode ohmique EO2. Les électrodes ES2 et EO2 sont reliées respectivement à deux bornes 24 et 25 permettant de connecter un circuit électrique comportant un générateur $G1'$ pour déplacer et collecter les électrons ayant transités du niveau $e_1$ vers le continuum des états libres. L'intensité du courant circulant dans ce circuit permet de mesurer la puissance optique détectée.

Dans cet exemple de réalisation, le matériau $M_a$ de la couche 21 et les matériaux $M_a$ et $M_b$ de l'ensemble de couches 22 ont un dopage de type N mais le plus faible réalisable par la technologie connue, pour rendre minimal l'absorption de l'onde de la fréquence $\nu_1$ en l'absence de l'onde de commande. La couche 23 constitue le substrat du détecteur et comporte un dopage de type N très important, comme pour le premier exemple de réalisation, mais son épaisseur doit être réduite pour minimiser l'absorption de l'onde de fréquence $\nu_1$ et pour lui permettre de ressortir du détecteur en l'absence de l'onde de commande h. $\nu_2$. Pour la même raison, l'électrode ohmique EO2 est réalisée de manière à être transparente pour l'onde $\nu_1$.

La figure 4b représente un diagramme des niveaux d'énergie des porteurs dans les différentes couches de cet exemple de réalisation, lorsqu'aucune différence de potentiel n'est appliquée entre les bornes 24 et 25. L'ensemble des couches 22 comporte une pluralité de puits quantiques dans lesquels le niveau fondamental, $e_1$, est désert en l'absence d'une onde de commande $\nu_2$.

La figure 4c représente un diagramme des niveaux d'énergie des porteurs dans la bande de conduction et dans la bande de valence à travers les couches de cet exemple de réalisation, lorsque une différence de potentiel positive est appliquée à la borne 25 par rapport à la borne 24 et lorsque l'onde de commande h. $\nu_2$ illumine le détecteur. L'existence d'un faible champ électrique dû à l'effet Schottky, à proximité de l'électrode ES2, a été négligé et n'est pas représenté sur cette figure. Le champ électrique créé par les électrodes ES2 et EO2 est maximal à l'interface entre l'électrode ES2 et la couche 21, puis il décroît en direction de l'électrode EO2. La polarisation inverse doit être telle que la zone d'application du champ couvre la totalité des couches 22 et 23.

Lorsque l'onde de commande $\nu_2$ est appliquée, des électrons transitent du niveau permis $h_1$ de la bande de valence vers le niveau $e_1$ dans la bande de conduction, dans chaque puits quantique. L'énergie nécessaire à cette transition est apportée par l'onde de commande. Les électrons peuplant ainsi le niveau $e_1$ dans chaque puits quantique, transitent vers le continuum des états non liés, sous l'action de l'onde à détecteur h. $\nu_1$, puis sont entraînés par le champ électrique et sont collectés par l'électrode EO2.

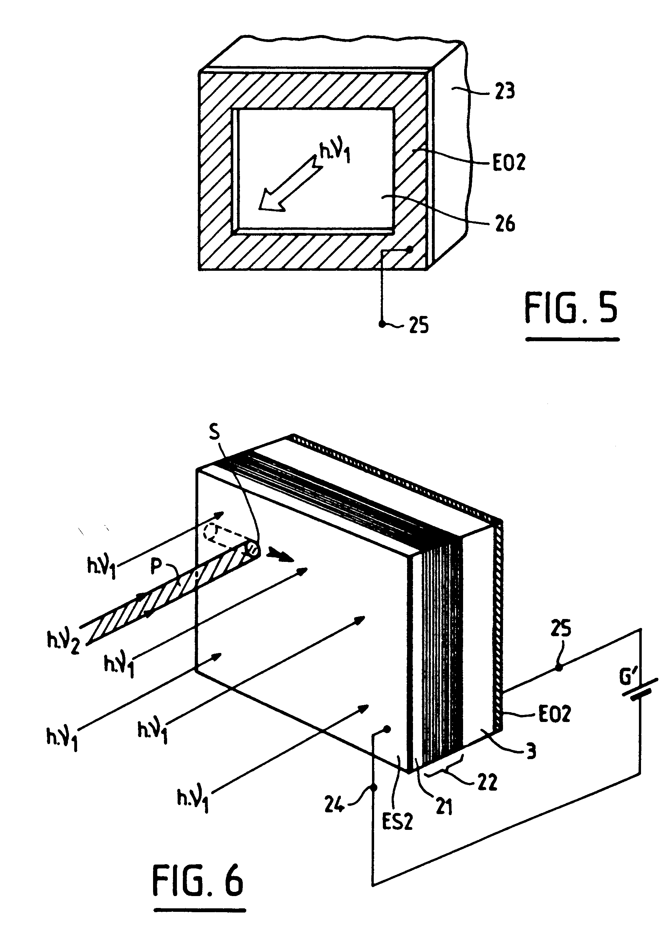

La figure 5 représente une partie de ce second exemple de réalisation. Pour réaliser une électrode EO2 couvrant toute la surface de la couche 23 mais étant transparente pour l'onde de fréquence $\nu_1$ lorsqu'elle n'est pas absorbée par le détecteur, il est possible d'utiliser une électrode EO2 non transparente mais qui ne couvre pas la totalité de la surface de la couche 23. L'électrode EO2 représentée sur la figure 5 ne couvre que la périphérie de la face externe de la couche 23. Une fenêtre 26 laisse libre la plus grande partie de la surface de la couche 23 et laisse passer l'onde de fréquence $\nu_1$. Le fort dopage de la couche 23 permet néanmoins d'obtenir un champ électrique relativement uniforme à l'intérieur du détecteur.

L'exemple de réalisation représenté sur la figure 4a peut être utilisé pour constituer un analyseur d'image. La figure 6 représente une telle utilisation. Des rayons lumineux de fréquence $\nu_1$ au moins égale à $\nu_1{}^0$, porteurs d'une image, sont projetés sur l'électrode ES2, par un dispositif optique classique non représenté, par exemple une lentille. Ils traversent l'électrode ES2 et la couche 21, puis forment une image sur l'ensemble 22 des couches constituant le multipuits quantique. Un pinceau P de lumière de fréquence $\nu_2$ est projeté sur l'électrode ES2 par des moyens de balayage optique classiques, non représentés. Le pinceau P balaye la surface des couches 22 selon un chemin prédéterminé réalisant un balayage systématique de l'ensemble de la surface de ces couches. La résolution du dispositif analyseur d'image ainsi constitué est liée à la dimension de la tache lumineuse S créée par le faisceau à la surface des couches 22 ; à la longueur de diffusion des électrons dans la direction du plan des couches ; et à la diffraction dans la couche 21.

La possibilité d'utiliser une onde de commande de fréquence $\nu_2$ appartenant à un domaine de longueurs d'onde très différent du domaine de longueurs d'onde à détecter permet, par exemple, d'analyser une image dans l'infra-rouge proche au moyen d'un faisceau appartenant au domaine infra-rouge moyen, en utilisant des matériaux semi-conducteurs III-V, et en particulier des alliages du type $Al_xGa_{1-x}As$, dont la technologie est classique.

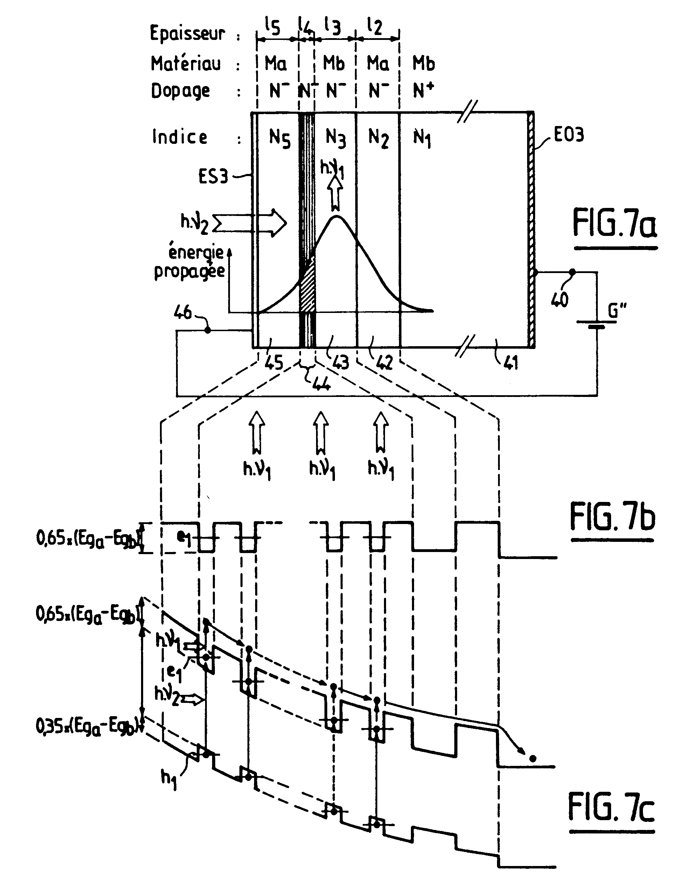

La figure 7a représente schématiquement un troisième exemple de réalisation du détecteur selon l'invention, pour détecter une onde de fréquence $\nu_1$ guidée selon une seule dimension, et conformément à la seconde variante. L'onde à détecter, h. $\nu_1$, est appliquée parallèlement au plan des couches constituant le détecteur alors que l'onde de commande, h. $\nu_2$, est appliquée perpendiculairement à ces couches. Cet exemple de réalisation comporte : une électrode ohmique, EO3 ; une couche 41 constituée de matériau semi-conducteur $M_b$ et qui est le substrat du détecteur ; une couche 42 constituée de matériau $M_a$ ; une couche 43 constituée de matériau $M_b$ ; un ensemble de couches 44 constituant un multipuits quantique et comportant une alternance de couches de matériau $M_a$ et de matériau $M_b$ ; une couche 45 constituée de matériau $M_a$ ; et une électrode Schottky ES3. Les électrodes ES3 et EO3 sont reliées respectivement par des bornes 46 et 40, à un circuit électrique comportant un générateur $G''$. L'intensité du courant dans ce circuit électrique traduit la puissance optique de l'onde détectée.

La couche 41 a un dopage de type N, important pour permettre l'obtention d'un contact ohmique pour appliquer un champ électrique à travers toutes les couches du détecteur. L'ensemble des couches 44 a les mêmes caractéristiques que l'ensemble des couches 22 dans l'exemple de réalisation précédent. Leur dopage est de type N et est le plus faible possible. De même, les couches 42, 43, 45 ont un dopage du type N le plus faible possible. Les couches 42, 43, 45 ont surtout pour rôle d'améliorer le confinement du mode fondamental du guide dans l'ensemble des couches 44 et de limiter le recouvrement de la zone de propagation de ce mode avec la couche de substrat 41 et avec l'électrode ES3. Ainsi l'efficacité du détecteur est augmentée et les pertes de propagation subies par le mode fondamental sont réduites. Les couches 41, 42, 43, 45 ont respectivement des indices optiques $N_1$, $N_2$, $N_3$, $N_5$ tels que $N_2$ est égal à $N_5$ et est compris entre $N_1$ et $N_3$, pour mieux confiner l'onde de fréquence $\nu$. Le mode fondamental du guide est choisi pour propager l'onde à détecter, car c'est le mode le mieux confiné dans la zone faiblement dopée, et en particulier dans l'ensemble des couches 44. Un graphe superposé à la figure 7a indique la répartition de l'énergie propagée dans cette structure guidante, en fonction de l'abscisse dans les différentes couches de cette structure.

De nombreuses variantes de réalisation des couches 45, 43, 42 situées aux deux extrémités de multipuits quantique sont envisageables pour constituer une structure guidante telle qu'il y ait un bon recouvrement du ou des modes de l'onde à détecter h. $\nu_1$ avec la perturbation engendrée par l'onde de commande h. $\nu_2$ dans chaque couche de matériau $M_b$ du multipuits quantique. En règle générale, les 2 couches les plus extrêmes dans la structure du multipuits quantique ont des épaisseurs choisies telles qu'il y ait un bon recouvrement.

En l'absence de l'onde de commande h. $\nu_2$ , le détecteur est pratiquement transparent pour l'onde de fréquence $\nu_1$ , les seules pertes étant dues à l'absorption par les porteurs libres qui sont en grande concentration dans la couche 41 du substrat et dans le métal constituant l'électrode ES3. L'onde h. $\nu_1$ ressort alors parallèlement au plan des couches.

La figure 7b représente un diagramme des niveaux d'énergie des électrons dans la bande de conduction pour les différentes couches de cet exemple de réalisation, lorsqu'aucune différence de potentiel n'est appliquée entre les bornes 40 et 46. Le faible champ électrique dû à l'électrode Schottky a été négligé et n'est pas représenté. En l'absence de l'onde de commande h. $\nu_2$ , cette structure quantique possède une pluralité de puits quantiques dont le niveau fondamental $e_1$ dans la bande de conduction est désert.

La figure 7c représente un diagramme des niveaux d'énergie des électrons dans la bande de conduction et dans la bande de valence, à travers les différentes couches de cet exemple de réalisation, lorsqu'une différence de potentiel positive est appliquée à la borne 40 par rapport à la borne 46 et lorsque le détecteur est illuminé par l'onde de commande. Sous l'action de l'onde de commande, les électrons quittent le niveau fondamental $h_1$ de la bande de valence et vont peupler le niveau fondamental $e_1$ de la bande de conduction dans chacun des puits quantiques de l'ensemble de couches 44. Sous l'action de l'onde à détecter, h. $\nu_1$ , les électrons peuplant le niveau $e_1$ transitent vers le continuum des états non liés puis sont déplacés par le champ électrique en direction de l'électrode EO3. L'intensité du courant circulant dans le circuit électrique traduit la puissance optique de l'onde détectée. En l'absence d'éclairement, le niveau fondamental $e_1$ de la bande de conduction est désert, l'onde à détecter n'est pas absorbée. Elle peut donc traverser le détecteur en restant confinée et continuer sa route dans un guide optique.

Dans un exemple de réalisation, les couches 42, 43, 45 ont chacune une épaisseur de 3 micromètres et l'ensemble des couches 44 a une épaisseur d'environ 0,5 micromètre, en étant constitué de 50 puits créés chacun par une couche de matériau $M_a$ d'épaisseur 0,006 micromètre et une couche de matériau $M_b$ d'épaisseur 0,0024 micromètre. Les matériaux $M_a$ et $M_b$ sont respectivement constitués par $Ga_{0,85}Al_{0,15}As$ et GaAs. Les dopages $N^-$ des couches 42, 43, 45 sont de

$5.10^{14} cm^{-3}$. Le dopage $N^+$ de la couche 41 du substrat est de $2.10^{18} cm^{-3}$. Les indices optiques sont alors égaux à :

$N_3 = 3,27$
$N_2 = N_5 = 3,21$
$N_1 = 2,88$

Cet exemple de réalisation permet de détecter une onde de l'infra-rouge moyen, de longueur d'onde 10,6 micromètres, avec une onde de commande de longueur d'onde 0,83 micromètre, située dans le domaine de l'infra-rouge proche.

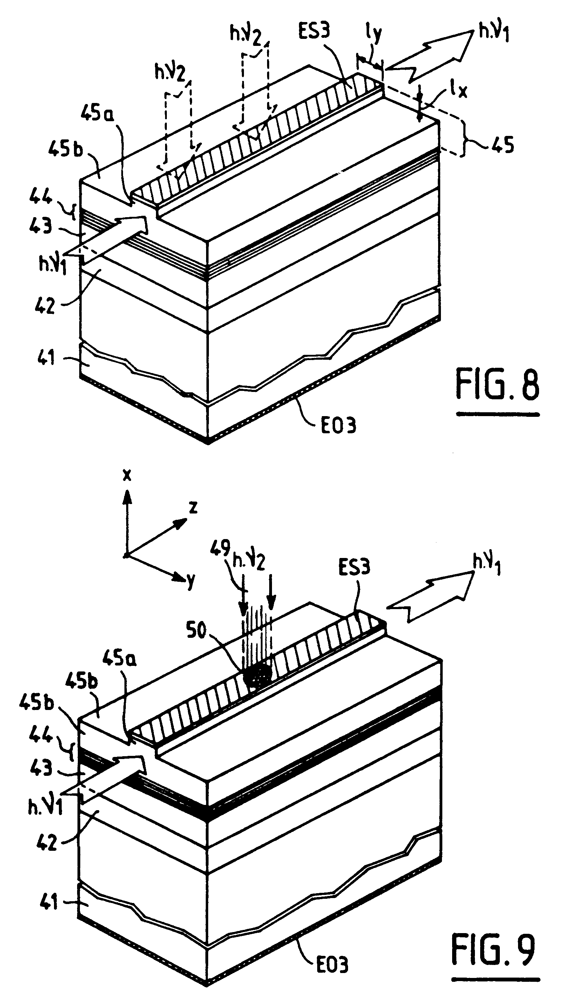

La figure 8 représente schématiquement un quatrième exemple de réalisation du détecteur selon l'invention, pour détecter une onde guidée selon deux dimensions, sous la commande d'une onde de fréquence $\nu_2$ . Cet exemple de réalisation est très proche de l'exemple de réalisation précédent, à l'exception de la couche 45 qui comporte une nervure plane 45a, située le long de son grand axe de symétrie et parallèle à la direction de propagation de l'onde à détecter. La nervure 45a est obtenue par une réduction $1_x$ de l'épaisseur de la couche 45, de part et d'autre de la nervure 45a. La couche 45 comporte donc une partie plane 45b située de part et d'autre de la nervure 45a. Le calcul de la largeur $1_y$ et de l'épaisseur $1_x$ de la nervure 45a est fait par un procédé classique, en fonction des modes de propagation souhaités dans la structure guidante. L'électrode ES3 ne couvre que la surface de la nervure 45a. L'éclairement par l'onde de commande h. $\nu_2$ est appliqué uniformément sur toute la surface de cette électrode ES3, perpendiculairement au plan des couches. Avec un tel détecteur, il est possible de réaliser des mesures de puissance optique dans un tronçon de guide optique bidimensionnel, en l'intégrant à ce guide.

Dans cet exemple de réalisation on a prévu que le peuplement en électrons de la bande de conduction du puits se fait sous l'effet d'une onde de pompe h $\nu_2$, mais ce peuplement peut se faire différemment comme cela a été décrit précédemment en relation avec la figure 1.

L'exemple de réalisation précédent peut être utilisé aussi pour réaliser une mesure plus localisée de la puissance optique se propageant à travers un guide. Comme représenté sur la figure 9, une mesure de la puissance optique à travers un très court tronçon de guide peut être réalisée en projetant un pinceau 49 de lumière de fréquence $\nu_2$ sur une surface 50 ayant la largeur de la nervure 45a et ayant une longueur aussi faible que possible pour faire une mesure pratiquement dans une section du guide. En déplaçant le faisceau lumineux le long de la nervure 45a il est possible de mesurer les variations de la puissance optique le long du guide. Il est possible par exemple de déterminer les pertes de propagation subies par un mode considéré au sein de ce guide.

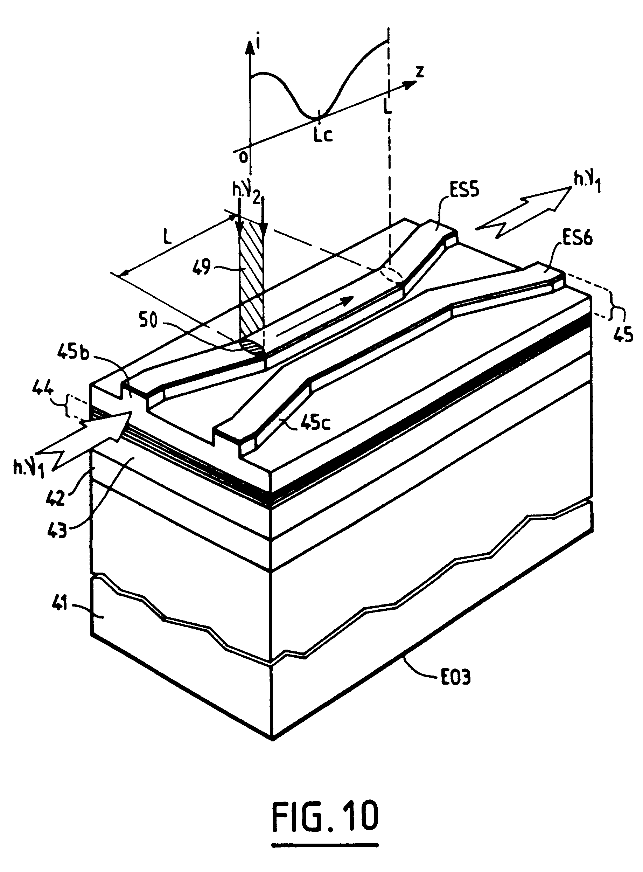

De même, cette technique de mesure permet de déterminer la longueur de couplage d'un coupleur directionnel. La figure 10 représente l'utilisation du détecteur selon l'invention pour mesurer la longueur de couplage d'un coupleur directionnel. Un tel coupleur comporte deux guides monomodes assez proches, sur une distance L appelée longueur d'interaction, pour qu'il y ait un couplage entre les deux guides. Ce couplage se traduit par un échange périodique d'énergie optique entre les deux guides et cet échange est total lorsque la structure est parfaitement symétrique.

Comme représenté sur la figure 10, les deux guides sont modifiés pour incorporer un détecteur ayant une structure semblable à celle représentée sur la figure 8. Les deux guides couplés sont fabriqués en amincissant la couche 45, pour créer deux nervures 45b et 45c comportant un segment où elles sont parallèles et très proches sur une longueur L. Elles sont chacune recouvertes d'une électrode, respectivement ES5 et ES6, pour recueillir un courant de mesure. Un pinceau 49 de lumière de fréquence $\nu_2$ éclaire une petite surface 50 du guide constitué par la nervure 45b, la petite surface 50 ayant une largeur égale à celle de la nervure 45b et ayant une longueur aussi faible que possible pour obtenir une mesure pratiquement dans une section du guide. Le pinceau 49 est déplacé le long du guide dans la partie constituant le coupleur. Le graphe montre la variation de l'intensité i du courant recueilli par l'électrode ES5, en fonction de l'abscisse z le long du guide. Ce courant passe par un minimum pour l'abscisse $L_c$ correspondant à L/2.

De nombreuses variantes sont à la portée de l'homme de l'Art, en modifiant le choix des matériaux pour détecter une onde de longueur d'onde appartenant à un domaine différent ou bien pour utiliser une onde de commande appartenant à un domaine de longueur d'onde différent. Il est aussi à la portée de l'homme de l'Art de réaliser d'autres structures de guides optiques incorporant le détecteur selon l'invention.

L'invention est applicable notamment au domaine de l'optique guidée intégrée.

**Revendications**

1. Détecteur d'onde électromagnétique pour détecter une onde de fréquence $\nu_1$, comportant :
   - au moins une première couche (2) de matériau semi-conducteur d'un premier type ($M_b$), et qui est traversée par l'onde à détecter ;
   - au moins deux secondes couches (1, 3), chaque première couche (2) étant placée entre deux secondes couches (1, 3) et ces secondes couches (2, 3) étant constituées d'un matériau semi-conducteur d'un second type ($M_a$), ces deux types de matériau étant tels qu'il y ait un puits de potentiel dans la bande de conduction et dans la bande de valence de chaque première couche (1) ;
   - deux électrodes disposées parallèlement auxdites couches (1, 2, 3) (ES1, EO1) pour appliquer un champ électrique, à l'ensemble des premières et des secondes couches (1, 2, 3) perpendiculairement à ces couches et pour recueillir un courant électrique fonction de l'amplitude de l'onde à détecter,
   
   caractérisé en ce que l'épaisseur ($1_b$) de chaque première couche (2) est telle que les électrons de la bande de conduction de chaque première couche (2) possèdent au moins un niveau discret d'énergie permis ($e_1$), tel que la différence d'énergie entre ce niveau ($e_1$), et le bas de la bande de conduction dans les secondes couches (1, 3) soit inférieure ou égale à l'énergie correspondant à la fréquence $\nu_1$ de l'onde à détecter ; ce niveau ($e_1$) étant peuplé d'électrons ; de plus les largeurs de bandes interdites de la première couche (2) et des secondes couches (1, 3) de matériaux semiconducteurs étant supérieures à l'énergie de l'onde à détecter.

2. Détecteur optique selon la revendication 1, caractérisé en ce que, pour que le niveau fondamental ($e_1$) de la bande de conduction de chaque première couche (2) soit peuplé d'électrons, le matériau de premier type ($M_b$) comporte un dopage de type N.

3. Détecteur selon la revendication 1, caractérisé en ce que, les premières et les secondes couches (1, 2, 3) ont un dopage aussi faible que possible ; et en ce que, pour que le niveau fondamental ($e_1$) de la bande de conduction de chaque première couche (2) soit peuplé d'électrons, celle-ci est illuminée par une onde de fréquence $\nu_2$ proche de la fréquence $\nu_2^0$ correspondant à la différence d'énergie entre le niveau fondamental ($h_1$) permis pour les trous dans la bande de valence, et le niveau fondamental ($e_1$) permis pour les électrons dans la bande de conduction du matériau du premier type ($M_b$).

4. Détecteur selon la revendication 3, caractérisé en ce que les deux électrodes (ES1, EO1) sont transparentes à la fréquence $\nu_1$ de l'onde à détecter.

**5.** Détecteur selon la revendication 3, pour détecter une onde (h. $\nu_1$) guidée selon une seule dimension, caractérisé en ce que les premières et les secondes couches (44) sont des couches planes ; en ce que l'onde guidée se propage à travers les premières et les secondes couches (44) parallèlement à leur plan ; en ce que l'épaisseur totale de ces couches (44) et leurs indices sont tels qu'ils assurent le guidage d'au moins un mode pour la gamme des fréquences ($\nu_1$) de l'onde à détecter ; et en ce que l'épaisseur des secondes couches les plus extrêmes est telle qu'il y ait un bon recouvrement du ou des modes de l'onde à détecter (h. $\nu_1$) avec une perturbation engendrée par l'onde de commande (h. $\nu_2$) dans chaque première couche (2).

**6.** Détecteur selon la revendication 1, pour détecter une onde (h. $\nu_1$) guidée selon deux dimensions, caractérisé en ce que les premières et les secondes couches (44) sont des couches planes ; en ce que l'onde guidée se propage à travers les premières et les secondes couches (44) parallèlement à leur plan ; en ce que l'épaisseur totale de ces couches (44) et leurs indices sont tels qu'ils assurent le guidage d'au moins un mode pour la gamme des fréquences ($\nu_1$) de l'onde à détecter ; et en ce que la seconde couche la plus superficielle (45) a une épaisseur non uniforme, cette couche (45) comportant une réduction d'épaisseur ($1_x$) uniforme, de part et d'autre d'une nervure (45a), dont le grand axe correspond à la direction de propagation de l'onde à détecter (h. $\nu_1$), la largeur ($1_y$) de la nervure (45b) et la réduction d'épaisseur ($1_x$) étant choisies en fonction des modes de propagation souhaités.

**7.** Analyseur d'image, caractérisé en ce qu'il comporte un détecteur selon la revendication 3, l'onde à détecteur (h. $\nu_1$) étant porteuse d'une image qui est projetée sur le plan des premières et secondes couches (22) ; et en ce qu'il comporte des moyens pour illuminer le détecteur avec une onde de commande (h. $\nu_2$), projetée sur le plan des premières et des secondes couches (22) en illuminant une surface (S) petite devant la surface totale du détecteur, et en balayant toute la surface du détecteur selon un chemin prédéterminé.

**Claims**

**1.** An electromagnetic wave detector for detecting a wave with the frequency $\nu_1$, comprising:
- at least one first layer (2) of a semiconductor material of a first type ($M_b$), which is traversed by the wave to be detected;
- at least two second layers (1, 3), each first layer (2) being arranged between two second layers (1, 3) and said second layers (1, 3) being constituted by a semiconductor material of a second type ($M_a$), said two types of material being such that there is a potential pit in the conduction band and in the valence band of each first layer (2);
- two electrodes (ES1, EO1) arranged in parallelism to the said layers (1, 2, 3) for the application of an electric field to the arrangement of the first and the second layers (1, 2, 3) perpendicularly to these layers and for collecting an electric current which is a function of the amplitude of the wave to be detected, characterized in that the thickness ($1_b$) of each first layer (2) is such that the electrons of the conduction band of each first layer (2) possess at least one permitted discrete energy level ($e_1$) such that the energy difference between the level ($e_1$) and the bottom of the conduction band in the second layers (1, 3) is less than or equal to the energy corresponding to the frequency $\nu1$ of the wave to be detected; said level ($e_1$) being populated with electrons; and furthermore the widths of the forbidden bands of the first layer (2) and of the second layers (1, 3) of the semiconductor materials being greater than the energy of the wave to be detected.

**2.** The optical detector as claimed in claim 1, characterized in that for the fundamental level ($e_1$) of the conduction band of each first layer (2) to be populated with electrons, the material of the first type ($M_b$) is N-doped.

**3.** The detector as claimed in claim 1, characterized in that the first and the second layers (1, 2, 3) have the lowest possible doping level; and in that for the fundamental level ($e_1$) of the conduction band of each first layer (2) to be populated with electrons, the same is illuminated by a wave with a frequency $\nu_2$ near the frequency $\nu_2{}^0$ corresponding to the energy difference between the fundamental level ($h_1$) permitted for the holes in the valence band, and the fundamental level ($e_1$) permitted for the electrons in the conduction band of the material of the first type ($M_b$).

**4.** The detector as claimed in claim 3, characterized in that the two electrodes (ES1, EO1) are transparent at the frequency $\nu_1$ of the wave to be detected.

5. The detector as claimed in claim 3 for the detection of a wave (h.$\nu_1$) guided in a single dimension, characterized in that the first and the second layers (44) are planar layers; in that the guided wave is propagated through the first and the second layers (44) in parallelism to their plane; in that the overall thickness of the said layers (44) and their indices are such that they ensure guiding of at least one mode for the range of frequencies ($\nu_1$) of the wave to be detected and in that the thickness of the outermost second layers is such that there is a good coverage of the mode or modes of the wave to be detected (h.$\nu_1$) with a perturbation caused by the control wave (h.$\nu_2$) in each first layer (2).

6. The detector as claimed in claim 1 for the detection of a wave (h.$\nu_1$) guided in two dimensions, characterized in that the first and the second layers (44) are planar layers; in that the guided wave is propagated through the first and the second layers (44) in parallelism to their plane; in that the overall thickness of the said layers (44) and their indices are such that they ensure guiding of at least one mode for the range of frequencies ($\nu_1$) of the wave to be detected and in that the second layer nearest the surface (45) has a non-uniform thickness, said layer (45) having a reduction in thickness ($l_x$) on either side of a rib (45a), whose major axis corresponds to the direction of propagation of the wave (h.$\nu_1$) to be detected, the width ($l_y$) of the rib (45b) and the reduction in thickness ($l_x$) being selected as a function of the desired modes of propagation.

7. An image analyzer, characterized in that it comprises a detector as claimed in claim 3, the wave to be detected (h.$\nu_1$) being carrier of an image which is projected on the plane of the first and the second layers (22); and in that it comprises means for illuminating the detector with a control wave (h.$\nu_2$) projected on the plane of the first and of the second layers (22), illuminating a surface (S) small against the overall surface of the detector and scanning all the surface of the detector along a predetermined path.

**Patentansprüche**

1. Detektor für elektromagnetische Wellen, zur Erfassung einer Welle der Frequenz $\nu_1$, mit:
   - wenigstens einer ersten Schicht (2) aus einem Halbleitermaterial eines ersten Typs (M_b), die von der zu erfassenden Welle durchlaufen wird;
   - wenigstens zwei zweiten Schichten (1, 3), wobei jede erste Schicht (2) zwischen zwei zweiten Schichten (1, 3) angeordnet ist und wobei diese zweiten Schichten (1, 3) aus einem Halbleitermaterial eines zweiten Typs (M_a) gebildet sind, wobei diese zwei Materialtypen von der Art sind, daß im Leitungsband und im Valenzband einer jeden ersten Schicht (2) ein Potentialtopf besteht;
   - zwei Elektroden (ES1, EO1), die parallel zu den erwähnten Schichten (1, 2, 3) angeordnet sind, um an die Gesamtheit der ersten und zweiten Schichten (1, 2, 3) senkrecht zu diesen Schichten ein elektrisches Feld anzulegen und um einen von der Amplitude der zu erfassenden Welle abhängenden elektrischen Strom aufzunehmen;
   dadurch gekennzeichnet, daß die Dicke ($l_b$) einer jeden ersten Schicht (2) derart ist, daß die Elektronen des Leitungsbandes einer jeden ersten Schicht (2) wenigstens ein erlaubtes diskretes Energieniveau ($e_1$) besitzen, derart, daß die Energiedifferenz zwischen diesem Niveau ($e_1$) und dem unteren Ende des Leitungsbandes in den zweiten Schichten (1, 3) kleiner oder gleich der der Frequenz $\nu_1$ der zu erfassenden Welle entsprechenden Energie ist, wobei dieses Niveau ($e_1$) von Elektronen besetzt ist, und wobei außerdem die Breiten der verbotenen Bänder der ersten Schicht (2) und der zweiten Schichten (1, 3) aus Halbleitermaterialien größer als die Energie der zu erfassenden Welle sind.

2. Optischer Detektor gemäß Anspruch 1, dadurch gekennzeichnet, daß das Material des ersten Typs (M_b) eine Dotierung vom N-Typ aufweist, damit das Grundniveau ($e_1$) des Leitungsbandes einer jeden ersten Schicht (2) mit Elektronen besetzt ist.

3. Detektor gemäß Anspruch 1, dadurch gekennzeichnet, daß die ersten und die zweiten Schichten (1, 2, 3) eine Dotierung besitzen, die so schwach wie möglich ist; und daß um das Grundniveau ($e_1$) des Leitungsbandes einer jeden ersten Schicht (2) mit Elektronen zu besetzen jede erste Schicht (2) mit einer Welle bestrahlt wird, deren Frequenz $\nu_2$ sich nahe bei der Frequenz $\nu_2{}^0$ befindet, die der Energiedifferenz zwischen dem für die Löcher im Va-

lenzband erlaubten Grundniveau ($h_1$) und dem für die Elektronen im Leitungsband des Materials des ersten Typs ($M_b$) erlaubten Grundniveau ($e_1$) entspricht.

4. Detektor gemäß Anspruch 3, dadurch gekennzeichnet, daß die zwei Elektroden (ES1, EO1) für die Frequenz $\nu_1$ der zu erfassenden Welle durchlässig sind.

5. Detektor gemäß Anspruch 3 für die Erfassung einer in einer einzigen Raumrichtung geführten Welle ($h \cdot \nu_1$), dadurch gekennzeichnet, daß die ersten und die zweiten Schichten (44) ebene Schichten sind; daß die geführte Welle sich durch die ersten und die zweiten Schichten (44) parallel zu deren Ebene ausbreitet; daß die Gesamtdicke dieser Schichten (44) und ihre Brechungsindizes derart sind, daß sie für den Bereich der Frequenzen ($\nu_1$) der zu erfassenden Welle die Führung wenigstens einer Mode gewährleisten; und daß die Dicke der äußersten zweiten Schichten derart ist, daß eine gute Abdeckung der Mode(n) der zu erfassenden Welle ($h \cdot \nu_1$) bei einer von der Steuerwelle ($h \cdot \nu_2$) in jeder ersten Schicht (2) erzeugten Störung besteht.

6. Detektor gemäß Anspruch 1 für die Erfassung einer in zwei Raumrichtungen geführten Welle ($h \cdot \nu_1$), dadurch gekennzeichnet, daß die ersten und die zweiten Schichten (44) ebene Schichten sind; daß die geführte Welle sich durch die ersten und die zweiten Schichten (44) parallel zu deren Ebene ausbreitet; daß die Gesamtdicke dieser Schichten (44) und deren Brechungsindizes derart sind, daß sie für den Bereich der Frequenzen ($\nu_1$) der zu erfassenden Welle die Führung wenigstens einer Mode gewährleisten; und daß die oberste zweite Schicht (45) eine ungleichmäßige Dicke hat, wobei diese Schicht (45) auf beiden Seiten einer Rippe (45a), deren Längsachse der Ausbreitungsrichtung der zu erfassenden Welle ($h \cdot \nu_1$) entspricht, eine gleichmäßige Verringerung der Dicke ($l_x$) aufweist, wobei die Breite ($l_y$) der Rippe (45b) und die Verringerung der Dicke ($l_x$) in Abhängigkeit von den gewünschten Ausbreitungsmoden gewählt werden.

7. Bildanalysator, dadurch gekennzeichnet, daß er einen Detektor gemäß Anspruch 3 aufweist, wobei die zu erfassende Welle ($h \cdot \nu_1$) Träger eines Bildes ist, das auf die Ebene der ersten und der zweiten Schichten (22) projiziert wird; und daß er Mittel zum Bestrahlen des Detektors mit einer Steuerwelle ($h \cdot \nu_2$) aufweist, die auf die Ebene der ersten und der zweiten Schichten (22) projiziert wird und dabei eine gegenüber der Gesamtfläche des Detektors kleine Oberfläche (S) bestrahlt und die gesamte Fläche des Detektors auf einem vorgegebenen Weg abtastet.

Etats non liés

Bande de conduction

$0,65 \times (Eg_a - Eg_b)$

$h.\nu_1^\circ$

$h.\nu_1$

$e_1$

$h.\nu_2^\circ$

$Eg_b$

$Eg_a$

$0,35 \times (Eg_a - Eg_b)$

$h_1$

$l_b$

Bande de valence

Matériau :  Ma   Mb   Ma

couche 1   couche 2   couche 3

FIG. 1

Etats libres

117 meV

$h.\nu_1^\circ = 70$ meV

$e_1$

$Eg_a = 1611$ meV

$Eg_b = 1424$ meV

$h.\nu_2^\circ = 1485$ meV

$hh_1$

$lh_1$

$hh_2$

$l_b = 0,006 \mu m$

Matériau : $Ga_{0,85} Al_{0,15} As$   GaAs   $Ga_{0,85} Al_{0,15} As$

FIG. 2

13

Matériau :   Ma | M.P.Q. | Mb

Dopage   :   N⁻ | N | N⁺

ES1

h.ν1

14

z

x

y

11

12

13

## FIG.3a

E01

15

G

$0,65 \times (Eg_a - Eg_b)$

la      lb

e1

## FIG.3b

$0,65 \times (Eg_a - Eg_b)$

h.ν1

e1

## FIG.3c

Matériau : | Ma | M.P.Q. | Mb
Dopage : | $N^-$ | $N^-$ | $N^+$

ES2 — EO2

$h.\nu_2$ $\Sigma$

$h.\nu_1$

$h.\nu_2$ $\Sigma$

$h.\nu_1$

25

24

21  22  23

G'

__FIG.4a__

$0,65 \times (Eg_a - Eg_b)$   $e_1$

__FIG.4b__

$0,65 \times (Eg_a - Eg_b)$

$h.\nu_1$

$e_1$

$Eg_b$   $h.\nu_2$

$0,35 \times (Eg_a - Eg_b)$

$h_1$

__FIG.4c__

FIG. 5

FIG. 6

FIG.7a

FIG.7b

FIG.7c

FIG.8

FIG.9

FIG. 10